# EUROPEAN PATENT APPLICATION

(11) **EP 4 601 200 A1**
(43) Date of publication of application: **13.08.2025**
(21) Application number: 23884207.4
(22) Date of filing: 25.06.2023
(51) Int. Cl.: H03M 7/30

(54) **RADAR DATA ENCODING METHOD AND DECODING METHOD, ENCODING APPARATUS, AND DECODING APPARATUS**

(30) Priority: 02.11.2022 CN 202211362992
(71) Applicant: Huawei Technologies Co., Ltd., Shenzhen, Guangdong 518129 (CN)
(72) Inventor: TU, Chenxi, Shenzhen, Guangdong 518129 (CN); CHEN, Weilan, Shenzhen, Guangdong 518129 (CN); CAI, Kangying, Shenzhen, Guangdong 518129 (CN)
(74) Representative: Eisenführ Speiser
(86) International application number: PCT/CN2023/102054
(87) International publication number: WO 2024/093268

(57) **Abstract**

A radar data encoding method is provided, including: obtaining to-be-encoded data, where the to-be-encoded data includes first attribute data, second attribute data, and third attribute data of different modals; encoding the first attribute data, to obtain first encoded data; predicting the second attribute data and the third attribute data based on the first attribute data, to obtain a predicted value of the second attribute data and a predicted value of the third attribute data; encoding the second attribute data based on the predicted value of the second attribute data, to obtain second encoded data; and encoding the third attribute data based on the predicted value of the third attribute data, to obtain third encoded data. According to the radar data encoding method provided in this application, compression efficiency of radar data is improved through cross-modal prediction.

## Description

This application claims priority to Chinese Patent Application No. 202211362992.3, filed on November 2, 2022 and entitled "RADAR DATA ENCODING AND DECODING METHOD, ENCODING APPARATUS, AND DECODING APPARATUS", which is incorporated herein by reference in its entirety.

### TECHNICAL FIELD

This application relates to the field of data compression technologies, and in particular, to a radar data encoding and decoding method, an encoding apparatus, and a decoding apparatus.

### BACKGROUND

Point cloud data obtained by a lidar plays an important role in algorithm modules (location, obstacle avoidance, and the like) of autonomous driving. In recent years, with evolution of lidar technologies, durability of lidars is greatly improved, and a unit price is also reduced to a level acceptable to the market. Various types of automotive-grade lidars are emerging one after another. Now the lidar has become a standard sensor for level 4 autonomous driving, and has been adopted by many mass-production vehicles.

At the same time, data transmission of the lidar is also a main challenge. With the pursuit of high-resolution point cloud, a quantity of lines of a lidar is increasing. Transmission of raw data of a single lidar may require a bandwidth over 100 Mbps. For security and reliability, an autonomous driving vehicle is usually equipped with a plurality of sensors such as a camera and a millimeter-wave radar. This brings greater pressure on data transmission and storage. To meet requirements of data transmission and storage of a lidar, an efficient compression algorithm is indispensable.

### SUMMARY

Embodiments of this application provide a radar data encoding and decoding method, an encoding apparatus, and a decoding apparatus, to improve compression efficiency of radar data through cross-modal prediction.

According to a first aspect, this application provides a radar data encoding method, including: obtaining to-be-encoded data, where the to-be-encoded data is raw data or point cloud data of a radar, and when the to-be-encoded data is the raw data, the to-be-encoded data includes first attribute data, second attribute data, and third attribute data of different modals; encoding the first attribute data, to obtain first encoded data; predicting the second attribute data and the third attribute data based on the first attribute data, to obtain a predicted value of the second attribute data and a predicted value of the third attribute data; encoding the second attribute data based on the predicted value of the second attribute data, to obtain second encoded data; and encoding the third attribute data based on the predicted value of the third attribute data, to obtain third encoded data. According to the radar data encoding method provided in this application, compression efficiency of radar data is improved through cross-modal prediction.

According to the radar data encoding method provided in this application, a correlation between attribute data of different modals of the radar data is used, and attribute data of each modal is encoded through cross-modal prediction, to improve compression efficiency of the radar data.

In a possible implementation, the predicting the second attribute data and the third attribute data based on the first attribute data, to obtain a predicted value of the second attribute data and a predicted value of the third attribute data includes: an attribute value corresponding to a first moment in the first attribute data being 0, and both predicted values corresponding to the first moment in the second attribute data and the third attribute data being 0, where the attribute data with a predicted value 0 is configured to skip being encoded.

For example, when the first attribute data, the second attribute data, and the third attribute data are signal intensity, reflectivity, and distance information respectively, when one piece of information is 0, for example, when the distance is 0, both signal intensity and reflectivity corresponding to the distance are usually 0. This is because when the distance is 0, it indicates that a signal is very weak and valid information cannot be obtained. Therefore, the distance data is ignored, and correspondingly, both the signal intensity and the reflectivity corresponding to the distance data are denoted as 0. For another example, when the signal intensity is 0, it indicates that there is no signal or a signal is very weak, and valid information cannot be obtained. Therefore, both reflectivity and distance information corresponding to the signal intensity are denoted as 0. Therefore, it may be considered to perform cross-modal encoding on the three to improve a compression ratio of the radar data.

An encoder side may skip data with an attribute value 0 without encoding the data, and a position is not reserved for the attribute data with a value 0 in a data stream. In this way, when the encoder side encodes multi-modal attribute data, the attribute data with a value 0 may be considered nonexistent. This can greatly reduce a data amount. More values 0 indicate higher compression efficiency, to further save a bandwidth during data transmission.

In another possible implementation, the predicting the second attribute data and the third attribute data based on the first attribute data, to obtain a predicted value of the second attribute data and a predicted value of the third attribute data includes: obtaining a change characteristic of the first attribute data; determining a predicted value of the second attribute data in a current frame based on the change characteristic of the first attribute data and an attribute value of the second attribute data in an encoded frame; and determining a predicted value of the third attribute data in the current frame based on the change characteristic of the first attribute and an attribute value of the third attribute data in the encoded frame, where the change characteristic indicates a change characteristic of the first attribute data between a frame corresponding to the encoded frame and a frame corresponding to the current frame.

For example, when the first attribute data is a signal intensity, and the second attribute is a distance, for distance data that needs to be encoded, when distance data at a moment t is to be encoded, an optical flow *I* is first calculated by using encoded signal intensity data at moments t and t-1, and then a distance *d̂*(*t*) *= f*(*I, d*(*t -* 1)) at the moment t is predicted by using the optical flow *I* and an encoded distance at the moment t-1. Similarly, the predicted value of the third attribute data at the current moment is predicted.

In another possible implementation, a specific implementation of obtaining a change characteristic of the first attribute data is: determining the change characteristic of the first attribute data based on an attribute value of an attribute value of the first attribute data in the frame corresponding to the encoded frame and an attribute value of the first attribute data corresponding to the current frame.

Optionally, the first attribute data, the second attribute data, and the third attribute data each are any one of distance information, signal intensity information, angle information, and reflectivity information.

In another possible implementation, when the to-be-encoded data is the point cloud data, the to-be-encoded data includes fourth attribute data, fifth attribute data, and sixth attribute data of different modals. The radar data encoding method provided in this embodiment of this application further includes: separately encoding the fourth attribute data and the fifth attribute data, to obtain fourth encoded data and fifth encoded data; predicting the sixth attribute data based on the fourth attribute data and the fifth attribute data, to obtain a predicted value of the sixth attribute; and encoding the sixth attribute based on the predicted value of the sixth attribute, to obtain sixth encoded data.

In this possible implementation, cross-modal prediction is implemented by using a correlation between attribute data of different modals of a lidar, to improve prediction accuracy, and even directly predict an accurate value of some attribute data. More accurate prediction enables more concentrated distribution (near a value 0) of encoded residuals. In this way, compression performance is improved in cooperation with entropy encoding.

In an example, a specific implementation of predicting the sixth attribute data based on the fourth attribute data and the fifth attribute data, to obtain a predicted value of the sixth attribute is: obtaining change characteristics of the fourth attribute data and the fifth attribute data; and determining a predicted value of the sixth attribute data in a current frame based on the change characteristics of the fourth attribute data and the fifth attribute data and an attribute value of the sixth attribute data in an encoded frame, where the change characteristics indicate change characteristics of the fourth attribute data and the fifth attribute data between a frame corresponding to the encoded frame and a frame corresponding to the current frame.

In another possible implementation, a specific implementation of obtaining change characteristics of the fourth attribute data and the fifth attribute data includes: determining an attribute value of the fourth attribute data and the change characteristic of the fifth attribute data based on an attribute value of the fourth attribute data and an attribute value of the fifth attribute data in the frame corresponding to the encoded frame, and an attribute value of the fourth attribute data and an attribute value of the fifth attribute data in the frame corresponding to the current frame.

According to a second aspect, an embodiment of this application further provides a radar data decoding method, including: when radar data is raw data, obtaining first encoded data; decoding the first encoded data, to obtain first attribute data; predicting second attribute data and third attribute data based on the first attribute data, to obtain a predicted value of the second attribute data and a predicted value of the third attribute data; decoding second encoded data and third encoded data, to obtain a residual value of the second attribute data and a residual value of the third attribute data; obtaining the second attribute data based on the predicted value of the second attribute data and the residual value of the second attribute data; and obtaining the third attribute data based on the predicted value of the third attribute data and the residual value of the third attribute data.

In a possible implementation, the radar data decoding method further provided in this embodiment of this application further includes: when the radar data is point cloud data, obtaining fourth encoded data and fifth encoded data; separately decoding the fourth encoded data and the fifth encoded data, to obtain fourth attribute data and fifth attribute data; predicting sixth attribute data based on the fourth attribute data and the fifth attribute data, to obtain a predicted value of the sixth attribute data; decoding sixth encoded data, to obtain a residual value of the sixth attribute data; and obtaining the sixth attribute data based on the predicted value of the sixth attribute data and the residual value of the sixth attribute data.

According to a third aspect, an embodiment of this application provides a radar data encoding apparatus, including an obtaining module, a first encoding module, and a first prediction module. The obtaining module is configured to obtain to-be-encoded data, where the to-be-encoded data is raw data or point cloud data of a radar, and when the to-be-encoded data is the raw data, the to-be-encoded data includes first attribute data, second attribute data, and third attribute data of different modals. The first encoding module is configured to encode the first attribute data, to obtain first encoded data. The first prediction module is configured to predict the second attribute data and the third attribute data based on the first attribute data, to obtain a predicted value of the second attribute data and a predicted value of the third attribute data. The first encoding module is further configured to encode the second attribute data based on the predicted value of the second attribute data, to obtain second encoded data; and encode the third attribute data based on the predicted value of the third attribute data, to obtain third encoded data.

In another possible implementation, the first prediction module is specifically configured to: an attribute value corresponding to a first moment in the first attribute data to be 0, and both predicted values corresponding to the first moment in the second attribute data and the third attribute data to be 0, where the attribute data with a predicted value 0 is configured to skip being encoded.

In another possible implementation, the first prediction module is specifically configured to: obtain a change characteristic of the first attribute data; determine a predicted value of the second attribute data in a current frame based on the change characteristic of the first attribute data and an attribute value of the second attribute data in an encoded frame; and determine a predicted value of the third attribute data in the current frame based on the change characteristic of the first attribute and an attribute value of the third attribute data in the encoded frame, where the change characteristic indicates a change characteristic of the first attribute data between a frame corresponding to the encoded frame and a frame corresponding to the current frame.

In another possible implementation, the obtaining a change characteristic of the first attribute data includes: determining the change characteristic of the first attribute data based on an attribute value of the first attribute data in the frame corresponding to the current frame and an attribute value of the first attribute data in the frame corresponding to the encoded frame.

In another possible implementation, the first attribute data, the second attribute data, and the third attribute data each are any one of distance information, signal intensity information, angle information, and reflectivity information.

In another possible implementation, when the to-be-encoded data is the point cloud data, the to-be-encoded data includes fourth attribute data, fifth attribute data, and sixth attribute data of different modals. The radar data encoding apparatus provided in this embodiment of this application further includes a second encoding module and a second prediction module. The second encoding module is configured to separately encode the fourth attribute data and the fifth attribute data, to obtain fourth encoded data and fifth encoded data. The second prediction module is configured to predict the sixth attribute data based on the fourth attribute data and the fifth attribute data, to obtain a predicted value of the sixth attribute. The second encoding module is further configured to encode the sixth attribute based on the predicted value of the sixth attribute, to obtain sixth encoded data.

In another possible implementation, the prediction module is specifically configured to: obtain change characteristics of the fourth attribute data and the fifth attribute data; and determine a predicted value of the sixth attribute data in a current frame based on the change characteristics of the fourth attribute data and the fifth attribute data and an attribute value of the sixth attribute data in an encoded frame, where the change characteristics indicate change characteristics of the fourth attribute data and the fifth attribute data between a frame corresponding to the encoded frame and a frame corresponding to the current frame.

In another possible implementation, an implementation of obtaining change characteristics of the fourth attribute data and the fifth attribute data includes: determining an attribute value of the fourth attribute data and the change characteristic of the fifth attribute data based on an attribute value of the fourth attribute data and an attribute value of the fifth attribute data in the frame corresponding to the encoded frame and an attribute value of the fourth attribute data and an attribute value of the fifth attribute data in the frame corresponding to the current frame.

According to a fourth aspect, an embodiment of this application further provides a radar data decoding apparatus, including a first obtaining module, a first decoding module, and a first prediction module. The first obtaining module is configured to: when radar data is raw data, obtain first encoded data. The first decoding module is configured to decode the first encoded data, to obtain first attribute data. The first prediction module is configured to predict second attribute data and third attribute data based on the first attribute data, to obtain a predicted value of the second attribute data and a predicted value of the third attribute data. The first decoding module is further configured to: decode second encoded data and third encoded data, to obtain a residual value of the second attribute data and a residual value of the third attribute data; obtain the second attribute data based on the predicted value of the second attribute data and the residual value of the second attribute data; and obtain the third attribute data based on the predicted value of the third attribute data and the residual value of the third attribute data.

In another possible implementation, the radar data decoding apparatus provided in this embodiment of this application further includes a second obtaining module, a second decoding module, and a second prediction module. The second obtaining module is configured to: when the radar data is point cloud data, obtain fourth encoded data and fifth encoded data. The second decoding module is configured to separately decode the fourth encoded data and the fifth encoded data, to obtain fourth attribute data and fifth attribute data. The second prediction module is configured to predict sixth attribute data based on the fourth attribute data and the fifth attribute data, to obtain a predicted value of the sixth attribute data. The second decoding module is further configured to: decode sixth encoded data, to obtain a residual value of the sixth attribute data, and obtain the sixth attribute data based on the predicted value of the sixth attribute data and the residual value of the sixth attribute data.

According to a fifth aspect, this application provides a computing device, including a memory and a processor. The memory stores executable code, and the processor executes the executable code to implement the method provided in the first aspect and/or the method provided in the second aspect of this application.

According to a sixth aspect, this application provides a computer-readable storage medium. The computer-readable storage medium stores a computer program, and when the computer program is executed on a computer, the computer is enabled to perform the method provided in the first aspect and/or the method provided in the second aspect of this application.

According to a seventh aspect, this application provides a computer program or a computer program product. The computer program or the computer program product includes instructions, and when the instructions are executed, the method provided in the first aspect and/or the method provided in the second aspect of this application are/is implemented.

### BRIEF DESCRIPTION OF DRAWINGS

FIG. 1 is a schematic flowchart of obtaining point cloud data by a lidar;
FIG. 2 is a diagram of an architecture of a lidar data transmission system;
FIG. 3 is a diagram of a structure of a codec according to an embodiment of this application;
FIG. 4 is a schematic flowchart of a radar data encoding method according to an embodiment of this application;
FIG. 5 is a diagram of predicting a predicted value of other attribute data when a signal intensity value is 0;
FIG. 6 is a diagram of predicting a predicted value of distance data when a signal intensity value is not 0;
FIG. 7 is a flowchart of a radar data encoding method applied to point cloud data encoding according to an embodiment of this application;
FIG. 8 is a flowchart of a radar data decoding method according to an embodiment of this application;
FIG. 9 is a flowchart of a radar data decoding method according to an embodiment of this application;
FIG. 10 is a diagram of a structure of a radar data encoding apparatus according to an embodiment of this application;
FIG. 11 is a diagram of a structure of a radar data decoding apparatus according to an embodiment of this application; and
FIG. 12 is a diagram of a structure of a computing device according to an embodiment of this application.

### DESCRIPTION OF EMBODIMENTS

The technical solutions of this application are further described in detail with reference to accompanying drawings and embodiments as follows.

To facilitate understanding of the radar data encoding and decoding method, the encoding apparatus, and the decoding apparatus provided in embodiments of this application, the following briefly describes some technical terms in embodiments of this application.

Point cloud (Point cloud): A point cloud is a dataset of points in a coordinate system. The point cloud includes abundant information, and usually includes three-dimensional coordinates X, Y, Z of points, even information such as a color, a classification value, and an intensity value. The three-dimensional real world can be restored by using dense point clouds. A point cloud of a lidar is usually obtained by calibrating packet data.

Packet data (Packet data): Packet data is a storage form of raw data of a lidar, and is obtained by sorting UDP data packets. The packet data includes information such as a distance, a rotation angle, a laser ID, a signal intensity (intensity), a reflectivity (reflectivity), and a timestamp of each point. A piece of packet data usually includes information during a plurality of emissions. Packet information may be directly input into a calibration algorithm, and after calibration, a point cloud is obtained. The calibration process is irreversible.

User datagram protocol (user datagram protocol, UDP) data packet: UDP protocol-based network transmission data. Direct output data of a lidar is transmitted in a form of a UDP packet. The UDP data packet is parsed and sorted, to obtain packet data.

Lidar raw data: UDP data packet or packet data.

One emission: a process in which a lidar emits all lasers and receives reflections. A quantity of points that can be obtained during one emission is related to a quantity of lines of the radar. For example, a 32-line radar can theoretically emit 32 lasers and receive 32 reflections during one emission. 32 points are obtained.

Attribute: One emission of a radar corresponds to a plurality of types of information: a distance, an angle (azimuth and elevation), a signal intensity (intensity), and the like, which are referred to as attributes. A modal described in embodiments of this application is a type of attribute data. For example, the distance, the angle, and the signal intensity belong to information of different modals. Packet data directly stores various attribute information. If the packet data is converted into a point cloud, distance and angle attributes are converted into a geometric attribute.

Lidar data compression methods may be roughly classified into two main types: one is to compress a point cloud, and the other is to compress raw data of a lidar, that is, a UDP data packet or packet data. Point cloud compression methods may be further classified into two types. One is a general point cloud compression algorithm that does not use a prior knowledge that a point cloud is from a lidar, for example, Google Draco or MPEG G-PCC (non-angular mode). The other is a point cloud compression algorithm specifically designed for LiDAR by using the prior knowledge that a point cloud is from LiDAR, for example, MPEG LiDAR Codec and the patent CN111699683A of DJI.

For a compression algorithm of raw data of a lidar, packet data is rearranged by using a working principle and data format of the radar, and then a corresponding encoding and decoding algorithm (for example, prediction and context) is designed or an existing image/video compression method is used for compression.

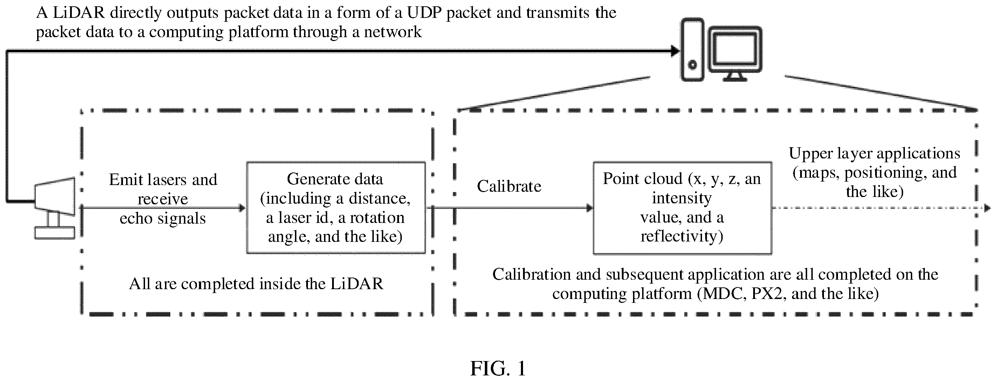

FIG. 1 is a schematic flowchart of obtaining a point cloud by a lidar. Point cloud data directly includes information such as geometric coordinates x, y, z and a reflectivity of each point, is intuitive, and can be directly input into algorithms such as positioning and target recognition. However, compared with raw data, some information and structures that are conducive to prediction have been changed. The raw data of the lidar is actual data transmitted in an autonomous driving vehicle. A data format and information in the data are more concentrated. This facilitates single-modal or cross-modal prediction, to compress data more effectively.

Regardless of the method used, and whether the point cloud or packet data is compressed, prediction is always one of most important tools for improving compression efficiency. Most prediction in the existing work is done only in a single modal.

A point cloud compression solution is a general point cloud algorithm based on an octree. A typical example is MPEG G-PCC (an angular mode is disabled). Essence of the algorithm is to enclose an entire point cloud with a bounding box (bounding box), and then perform octree subdivision on the point cloud. If there is still a node in a child node, further subdivision is performed until a size of each node reaches desired precision. By constructing the tree structure, lower-level geometric information can be used to predict higher-level geometric information. After the geometric information is encoded, signal intensity data is encoded. Similarly, encoded signal intensity data is used to encode uncompressed signal intensity data. In this solution, information of different modals is compressed independently, and a potential cross-modal correlation is not used.

Another compression solution is MPEG G-PCC LiDAR codec. Similar to the foregoing solution, this solution also compresses point cloud data. However, this solution uses the prior knowledge that the point cloud is from the lidar, attempts to convert the point cloud back to a form of the raw data of the lidar, and then compresses the raw data by using an existing tool such as CABAC.

As described above, a process of calibrating packet data to a point cloud is irreversible. Therefore, a main focus of this solution is how to convert the point cloud back to the raw data as accurately as possible. A structure of the raw data, and residuals of a distance, an angle, and coordinates need to be encoded, and then an attribute (for example, a signal intensity) needs to be encoded. The solution also makes prediction in each modal independently, without using a cross-modal attribute data correlation.

The lidar data (including raw data and point cloud data) has attribute data of a plurality of modals, for example, a distance, a signal intensity, an angle, and a reflectivity. The data of the plurality of modals has a correlation to some extent. In the foregoing solution, attribute data of each modal is independently predicted, and a correlation between data of different modals cannot be effectively used.

Embodiments of this application provide a radar data encoding and decoding method, an encoding apparatus, and a decoding apparatus, to perform cross-modal attribute data prediction by using a correlation between different modal attribute data of radar data, and encode the attribute data, to improve data compression efficiency.

The following specifically describes specific implementations of the radar data encoding and decoding method, the encoding apparatus, and the decoding apparatus that are provided in embodiments of this application.

With development of technologies, lidars that meet an automotive regulation and that are affordably priced gradually emerge. At the same time, the lidar brings a qualitative improvement and an essential performance improvement in applications such as automated emergency braking (AEB), and has gradually become a standard feature of mid- to high-end vehicles. Similar to a vehicle-mounted camera, radar data also needs to be stored and transmitted. Massive data of a plurality of high-line-count lidars needs to be supported by a compression algorithm. Embodiments of this application provide a series of cross-modal prediction methods for data compression/encoding/decoding of the lidar, to improve compression efficiency by using a correlation between different modal information.

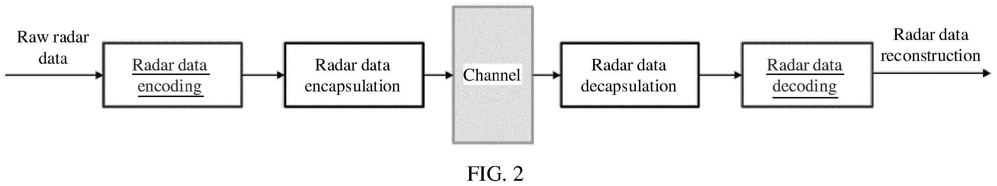

FIG. 2 shows a lidar data transmission system. The radar data encoding and decoding method, the encoding apparatus, and the decoding apparatus provided in embodiments of this application may be applied to the lidar data transmission system. As shown in FIG. 2, lidar data transmission mainly includes the following procedures: radar data encoding, radar data encapsulation, channel transmission, radar data decapsulation, and radar data decoding. A purpose of radar data encoding is to obtain an encoded file with a high compression ratio for transmission, and reduce a network transmission burden. A purpose of radar data decoding is to decode a data stream (that is, encoded data), to reconstruct radar data. Radar data encapsulation is to convert the encoded file into a format that is easy to transmit. In embodiments of this application, a radar data codec is improved, and encoding efficiency is improved.

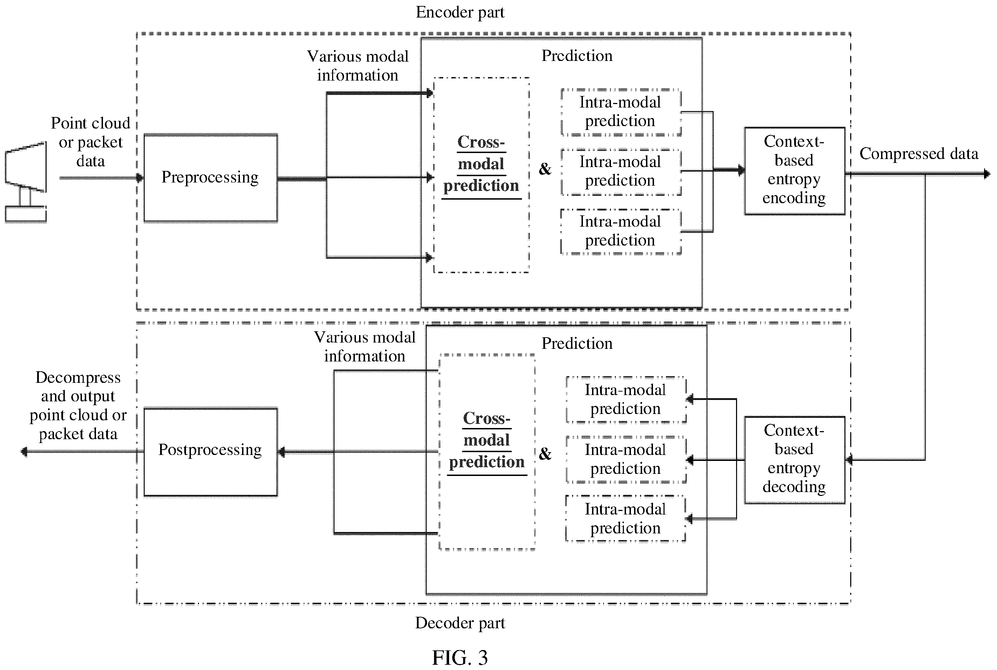

An improved codec is shown in FIG. 3. A cross-modal prediction part in a prediction module is improved in embodiments of this application. In most of the foregoing solutions, only intramodal prediction is performed. In embodiments of this application, more modals and a more complex prediction relationship and method are introduced.

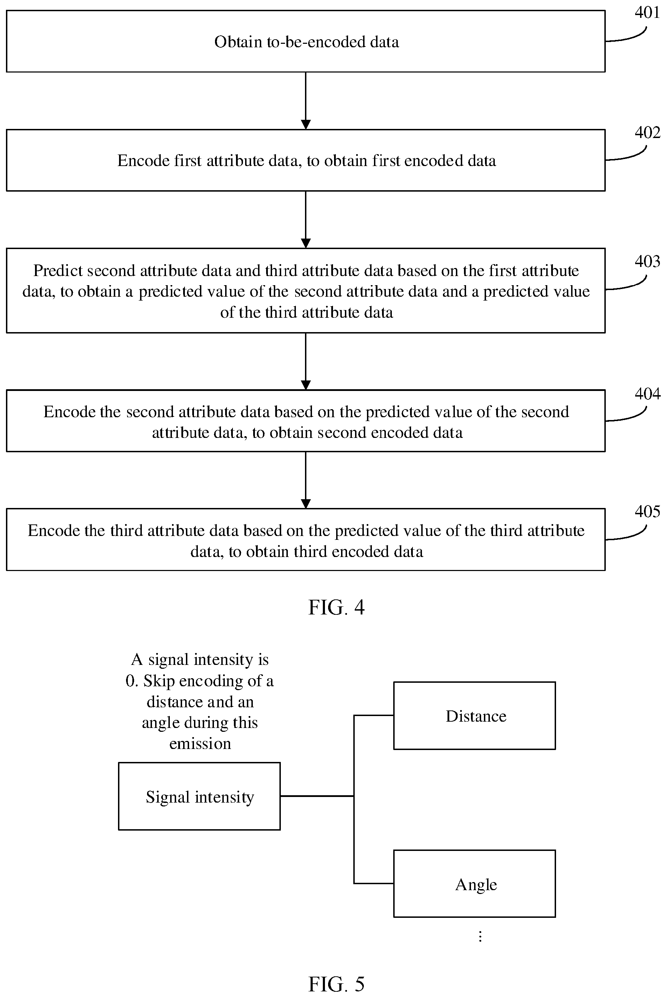

FIG. 4 is a schematic flowchart of a radar data encoding method according to an embodiment of this application. The method may be implemented in an encoder in FIG. 3. As shown in FIG. 4, the radar data encoding method provided in this embodiment of this application includes at least steps S401 to S404.

In step S401, to-be-encoded data is obtained.

The to-be-encoded data may be raw data or point cloud data of a radar. Herein, the to-be-encoded data that is the raw data of the radar is first described. The radar may be optionally a lidar or a microwave radar. Herein, the lidar is used as an example. Raw data of the lidar is a UDP data packet or packet data.

The UDP data packet contains additional information and measurement data. The additional information includes a global positioning system (global positioning system, GPS) timestamp, echo, and universal time coordinated (universal time coordinated, UTC) that are used to obtain time information. The measurement data includes M data blocks (block), each data block corresponds to one emission of the lidar, and one piece of angle (azimuth angle) measurement data and N (indicating that an N-line lidar has N laser emission modules) pieces of channel unit (channel unit) measurement data may be obtained during each emission. When the raw data is the UDP data packet, the UDP data packet needs to be processed to obtain packet data.

The packet data includes a plurality of data blocks, each data block corresponds to one emission of the lidar, and one data block includes one piece of angle measurement data and N groups of a plurality of types of attribute data of different modals, for example, distance data, signal intensity data, angle data, and reflectivity data. There is a one-to-one correspondence between a plurality of types of modal data.

The to-be-encoded data in this embodiment of this application is measurement data collected by the lidar during M times of emission, and M is greater than or equal to 1. A value of N, that is, a quantity of groups of measurement data, is related to a quantity of lines of the lidar. This is not specifically limited in this application.

After the packet data is obtained, the measurement data in the to-be-packetized data may be preprocessed. For example, attribute data of a plurality of different modals in the measurement data is separately sorted, to facilitate encoding compression on the attribute data of the plurality of different modals.

In step S402, first attribute data is encoded, to obtain first encoded data.

As described above, the raw data of the radar includes attribute data of a plurality of different modals, for example, distance data, angle data, and signal intensity data.

Attribute data of one of the modals may be first encoded. For example, the signal intensity data is first encoded.

In this embodiment, the signal intensity data may be encoded by using a plurality of encoding schemes, to obtain encoded signal intensity data. For example, the encoding scheme for the signal intensity data includes but is not limited to run-length encoding and entropy encoding.

In step S403, second attribute data and third attribute data are predicted based on the first attribute data, to obtain a predicted value of the second attribute data and a predicted value of the third attribute data.

There is a correlation between the attribute data of the plurality of modals of the radar data. Therefore, unencoded attribute data may be predicted by using the encoded attribute data and the correlation between the cross-modal attribute data, to obtain a predicted value of the other unencoded attribute data.

For example, an attribute value corresponding to a first moment in the first attribute data is 0, both predicted values corresponding to the first moment in the second attribute data and the third attribute data are 0, and the attribute data with a predicted value 0 is configured to skip being encoded.

When the first attribute data, the second attribute data, and the third attribute data are respectively signal intensity, angle, and distance information, the signal intensity is first encoded. When the angle and the distance are encoded, the encoded signal intensity data is referenced. If a signal intensity during this emission is 0, both an angle value and a distance value are 0. Therefore, the angle value and the distance value that are 0 may be directly skipped, and do not need to be encoded (refer to FIG. 5).

This is because when the signal intensity is 0, it indicates that there is no signal or a signal is very weak, and valid information cannot be obtained. Therefore, both the angle value and the distance value corresponding to the signal intensity are denoted as 0. Therefore, it may be considered to perform cross-modal encoding on the three to improve a compression ratio of the radar data.

In other words, an encoder side may skip data with an attribute value predicted as 0 without encoding the data, and a position is not reserved for the attribute data with a value 0 in a data stream. In this way, when the encoder side encodes multi-modal attribute data, the attribute data with a value 0 may be considered as nonexistent. This can greatly reduce a data amount. More values 0 indicate higher compression efficiency, to further save a bandwidth during data transmission.

For non-zero data in the first attribute data, a predicted value of other attribute data in a current frame may be predicted based on a change characteristic of the first attribute data and an attribute value of the other attribute data in an encoded frame. Herein, the current frame means a frame that is to be encoded. The encoded frame is a frame that has been encoded. The change characteristic of the first attribute data indicates a change characteristic of the first attribute data between the two frames corresponding to the encoded frame and the current frame of the to-be-encoded attribute data.

For example, if the to-be-encoded attribute data is the second attribute data, the encoded frame is the N^{th} frame, and the current frame (or referred to as a to-be-encoded frame) is the M^{th} frame, the change characteristic of the first attribute data is a change characteristic of the first attribute data between the N^{th} frame and the M^{th} frame.

A sequence of the encoded frame and the current frame is related to an encoding sequence of the second attribute data. When the second attribute data is encoded from front to back, the encoded frame is the N^{th} frames (that is, a historical frame) that is before the current frame. When the second attribute data is encoded from back to front, the encoded frame is the N^{th} frame (that is, a future frame) that is after the current frame. An order of the encoded frame is not specifically limited in this embodiment of this application.

Alternatively, the predicted value in the current frame may also be predicted through interpolation. For example, the encoded frames are the E^{th} frame and the F^{th} frame, and the current frame is the H^{th} frame. The H^{th} frame is a frame between the E^{th} frame and the F^{th} frame. In this case, the change characteristic of the first attribute data is a change characteristic of the first attribute data from the E^{th} frame and the F^{th} frame to the H^{th} frame. It may be understood that an attribute value at a moment described below has a same meaning as an attribute value in a frame.

In an example, a predicted value of the second attribute data at a current moment is determined based on the change characteristic of the first attribute data and an attribute value of the second attribute data at a previous moment. A predicted value of the third attribute data at the current moment is determined based on the change characteristic of the first attribute and an attribute value of the third attribute data at the previous moment.

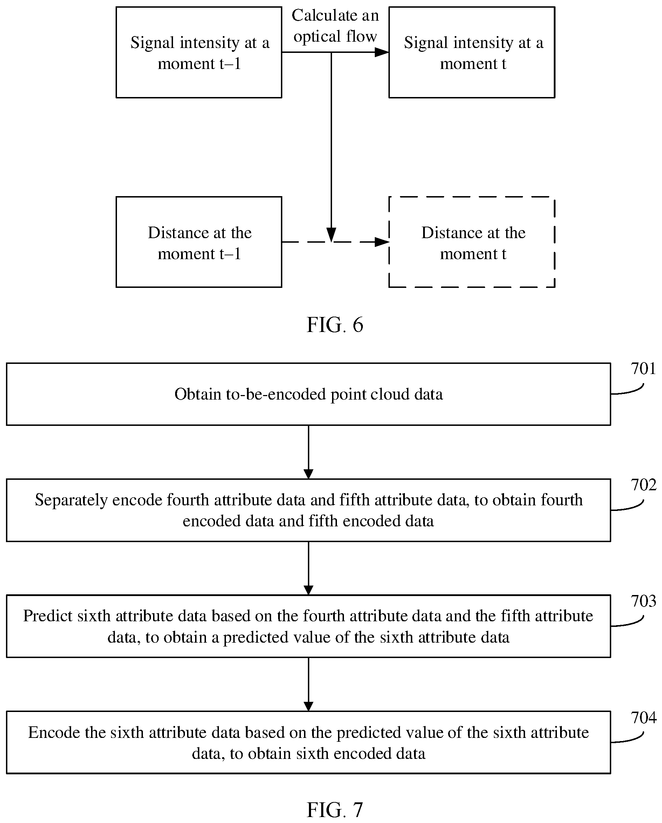

In an example, the change characteristic of the first attribute data may be an optical flow corresponding to the first attribute data. As shown in FIG. 6, for distance data that needs to be encoded, when distance data at a moment t is to be encoded, an optical flow *I* is first calculated by using encoded signal intensity data at the moments t and t-1, and then a distance *d̂*(*t*) = *f*(*I*, *d*(*t* - 1)) at the moment t is predicted by using the optical flow *I* and an encoded distance at the moment t-1. Similarly, the predicted value of the third attribute data at the current moment is predicted.

In step S404 and step S405, the second attribute data is encoded based on the predicted value of the second attribute data, to obtain second encoded data; and the third attribute data is encoded based on the predicted value of the third attribute data, to obtain third encoded data.

The attribute data is encoded based on the predicted value of the other unencoded attribute data obtained in step S403, to obtain encoded data.

For example, the unencoded second attribute data is distance data. A residual of the distance data may be calculated based on a predicted value that is of the distance data and that is obtained through prediction and an actual value (or referred to as a real value) of the distance data, and then the distance data is encoded based on a context and entropy encoding, to obtain encoded data of the distance data. Similarly, encoded data of the unencoded third attribute data is obtained, to compress the raw data of the radar.

In other words, according to the radar data encoding method provided in this embodiment of this application, when the raw data of the radar is to be encoded, attribute data of any of a plurality of modal attributes may be encoded in advance, and then cross-modal prediction is performed on any attribute data in other attribute data by using the encoded attribute data, to improve prediction accuracy. More accurate prediction enables more concentrated distribution (near a value 0) of residuals that need to be encoded. In this way, compression performance of the raw data of the radar is improved in cooperation with entropy encoding.

In another embodiment, the radar data encoding method provided in this embodiment of this application may be also applied to encoding and compressing point cloud data.

FIG. 7 is a flowchart of a radar data encoding method applied to point cloud data encoding according to an embodiment of this application. As shown in FIG. 7, the method includes at least steps S701 to S704.

In step S701, to-be-encoded point cloud data is obtained.

The to-be-encoded point cloud data may be obtained by calibrating packet data. The point cloud data includes attribute data of a plurality of modals, for example, geometric data (x, y, z), or referred to as location data, signal intensity, and reflectivity (reflectivity).

In step S702, fourth attribute data and fifth attribute data are separately encoded, to obtain fourth encoded data and fifth encoded data.

The fourth attribute data and the fifth attribute data may be any two of a plurality of pieces of cross-modal attribute data (for example, the geometric data, the signal intensity, and the reflectivity) included in the point cloud data.

For example, the geometric data and the signal intensity are separately encoded, to obtain encoded data corresponding to the geometric data and encoded data corresponding to the signal intensity data.

A specific scheme for encoding the geometric data and the signal intensity is not limited in this embodiment of this application, and may be any proper encoding scheme.

For example, the geometric data may be first encoded, and then the signal intensity is predicted by using the encoded geometric data, to obtain a predicted value of the signal intensity data. Then, a residual between the predicted value and an actual value of the signal intensity is calculated, and entropy encoding is performed based on the residual for encoding.

When geometric data in a same group is a value 0, it is determined that a predicted value of a signal intensity is a value 0. For geometric data that is not a value 0, the predicted value of the signal intensity may be predicted according to a preset polynomial. For example, the polynomial may be y=a*x+b, where y represents the geometric data, x represents the predicted value of the signal intensity, and a and b are parameters preset according to a correlation between the geometric data and the signal intensity.

If the geometric data is not a value 0, a change characteristic of the geometric data may be further determined based on geometric data at a current moment and at a previous moment, and a predicted value of the signal intensity at the current moment is predicted based on the change characteristic of the geometric data and a value of the signal intensity data at the previous moment. For example, when signal intensity in a frame t is to be encoded, a matching relationship *I =* {*x, y, z*}_{*t*-1} → {*x, y, z*}*ₜ* including a total of three-dimensional components may be constructed by using encoded geometric data in frames t and t-1, and a predicted value (t) = f(I, *i*(t - 1)) of the signal intensity data at the moment t is predicted with reference to the encoded signal intensity data at the moment t-1.

In step S703, sixth attribute data is predicted based on the fourth attribute data and the fifth attribute data, to obtain a predicted value of the sixth attribute.

A predicted value of other attribute data in the current frame may be predicted by using change characteristics of the fourth attribute data and the fifth attribute data and an attribute value of the other attribute data in an encoded frame. Herein, the current frame means a frame that is to be encoded. The encoded frame is a frame that has been encoded. The change characteristics of the fourth attribute data and the fifth attribute data indicate change characteristics of the fourth attribute data and the fifth attribute data between two frames corresponding to the encoded frame and the current frame of the to-be-encoded attribute data.

For example, if the to-be-encoded attribute data is the sixth attribute data, the encoded frame is the N^{h} frame, and the current frame (or referred to as a to-be-encoded frame) is the M^{th} frame, the change characteristics of the fourth attribute data and the fifth attribute data are change characteristics of the fourth attribute data and the fifth attribute data between the N^{th} frame and the M^{th} frame.

A sequence of the encoded frame and the current frame is related to an encoding sequence of the sixth attribute data. When the sixth attribute data is encoded from front to back, the encoded frame is the N^{th} frame (that is, a historical frame) that is before the current frame. When the sixth attribute data is encoded from back to front, the encoded frame is the N^{th} frame (that is, a future frame) that is after the current frame. An order of the encoded frame is not specifically limited in this embodiment of this application.

In an example, a predicted value of the sixth attribute data at the current moment may be determined by using the change characteristics of the fourth attribute data and the fifth attribute data and an attribute value of the sixth attribute data at the previous moment.

For example, the fourth attribute data is the geometric data, the fifth attribute data is the signal intensity data, and the sixth attribute is the reflectivity data. When a reflectivity in a frame t is to be encoded, a matching relationship I = {x, y, z, intensity}ₜ₋₁ → {x, y, z, intensity}, including a total of four-dimensional components may be constructed by using the encoded geometric and signal intensity (intensity) data in the frames t and t - 1, and the reflectivity at the moment t is predicted by using the encoded reflectivity at the moment t - 1: r̂(t) = f(I, r(t - 1)).

That is, cross-modal prediction may be performed on the attribute data of the other modal predicted by using the two types of encoded attribute data.

In step S704, the sixth attribute is encoded based on the predicted value of the sixth attribute, to obtain sixth encoded data.

The attribute data is encoded based on the predicted value of the other unencoded attribute data obtained in step S703, to obtain encoded data.

For example, the unencoded sixth attribute data is the reflectivity data. A residual of the reflectivity data may be calculated based on a predicted value that is of the reflectivity data and that is obtained through prediction and an actual value (or referred to as a real value) of the reflectivity data, and then the reflectivity data is encoded based on a context and entropy encoding, to obtain encoded data of the reflectivity data.

The radar data encoding method provided in this embodiment of this application may be applied to encoding and compression of the point cloud data of the radar. When the radar data is to be encoded, a correlation between different modal information of a lidar is better used. Attribute data of any two of a plurality of modal attributes is encoded in advance, and then cross-modal prediction is performed on any attribute data in other attribute data by using the encoded attribute data, to improve prediction accuracy. More accurate prediction enables more concentrated distribution (near a value 0) of residuals that need to be encoded. In this way, compression performance of the point cloud data of the radar is improved in cooperation with entropy encoding.

Correspondingly, an embodiment of this application further provides a radar data decoding method, which may be applied to a decoder, to decode encoded data encoded according to the radar data encoding method provided in embodiments of this application, and reconstruct radar data.

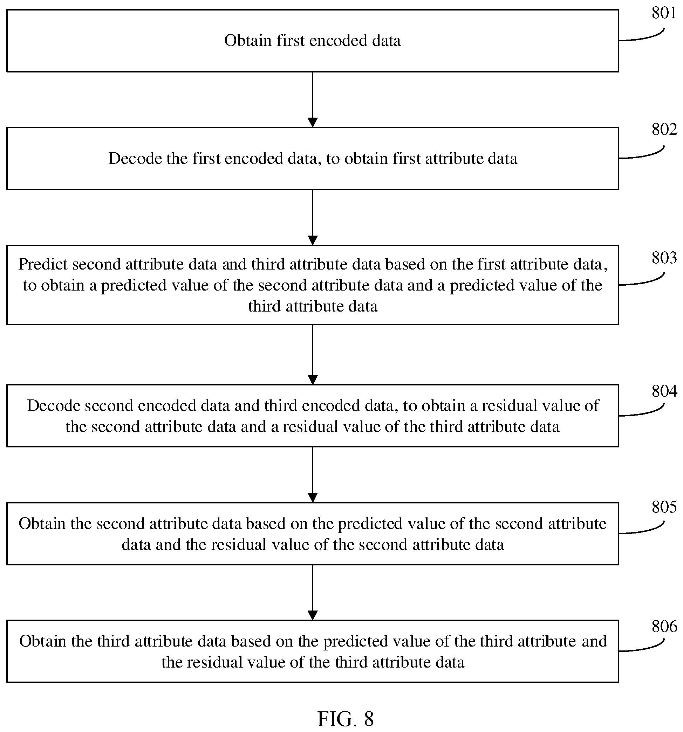

FIG. 8 is a flowchart of a radar data decoding method according to an embodiment of this application. The method is used to decode encoded data of raw data of a radar, to reconstruct the raw data of the radar. The method may be implemented in a decoder shown in FIG. 3. As shown in FIG. 8, the radar data decoding method provided in this embodiment of this application includes at least steps S801 to S806.

In step S801, first encoded data is obtained.

The first encoded data is encoded data of a first attribute data of the raw data of the radar, that is, encoded data of the signal intensity data described above.

In step S802, the first encoded data is decoded, to obtain the first attribute data.

When decoding is performed in the decoder, the encoded data corresponding to the first attribute data is first decoded, to reconstruct the first attribute data.

In step S803, second attribute data and third attribute data are predicted based on the first attribute data, to obtain a predicted value of the second attribute data and a predicted value of the third attribute data.

Then, when other attribute data, for example, encoded data of the second attribute data and encoded data of the third attribute data, is to be decoded, the attribute data of the first attribute data is referenced, for example, the signal intensity data described above. If the signal intensity data during this emission is 0, both a corresponding angle and a corresponding distance value are set to 0.

For a non-zero value in the signal intensity data, an angle and a distance are predicted with reference to the prediction method described above, to obtain a predicted value of the angle data and a predicted value of the distance data.

In step S804, the second encoded data and the third encoded data are decoded, to obtain a residual value of the second attribute data and a residual value of the third attribute data.

The encoded data of the second attribute data and the encoded data of the third attribute data are separately decoded, to obtain the residual value of the second attribute data and the residual value of the third attribute data.

Then, in step S805 and step S806, the second attribute data is obtained based on the predicted value of the second attribute and the residual value of the second attribute, and the third attribute data is obtained based on the predicted value of the third attribute and the residual value of the third attribute. Finally, the raw data of the radar is reconstructed.

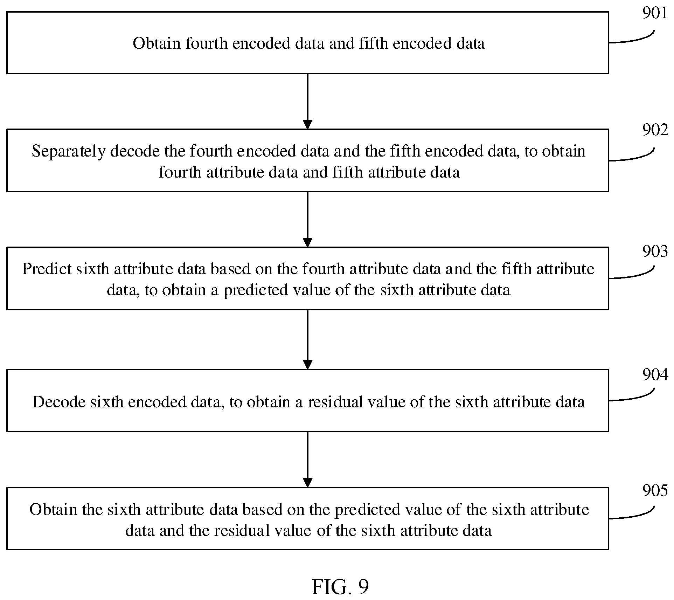

FIG. 9 is a flowchart of a radar data decoding method according to an embodiment of this application. The method is used to decode encoded data of point cloud data of a radar, to reconstruct the point cloud data of the radar. The method may be implemented in the decoder shown in FIG. 3. As shown in FIG. 9, the radar data decoding method provided in this embodiment of this application includes at least steps S901 to S905.

In step S901, fourth encoded data and fifth encoded data are obtained.

The fourth encoded data and the fifth encoded data are respectively encoded data of fourth attribute data and encoded data of fifth attribute data of the point cloud data of the radar. That is, the encoded data of the geometric data and the encoded data of the signal intensity data described above.

In step S902, the fourth encoded data and the fifth encoded data are separately decoded, to obtain the fourth attribute data and the fifth attribute data.

When decoding is performed in the decoder, the encoded data corresponding to the fourth attribute data and the fifth attribute data is first decoded, to reconstruct the fourth attribute data and the fifth attribute data.

In step S903, sixth attribute data is predicted based on the fourth attribute data and the fifth attribute data, to obtain a predicted value of the sixth attribute data.

Then, when other attribute data, for example, encoded data of the sixth attribute data, is to be decoded, the fourth attribute data and the fifth attribute data are referenced, for example, the foregoing geometric data and signal intensity data. If both the geometric data and the signal intensity data during this emission are 0, a corresponding reflectivity is set to 0.

For a non-zero value in the geometric data and the signal intensity data, the reflectivity is predicted with reference to the prediction method described above, to obtain a predicted value of the reflectivity.

In step S904, the sixth encoded data is decoded, to obtain a residual value of the sixth attribute data.

The encoded data of the sixth attribute data is decoded, to obtain the residual value of the sixth attribute data.

Then, in subsequent step S905, the sixth attribute data is obtained based on the predicted value of the sixth attribute data and the residual value of the sixth attribute data, and finally the point cloud data of the radar is reconstructed.

Based on a same concept as the foregoing embodiment of the radar data encoding method, an embodiment of this application further provides a radar data encoding apparatus 1000. The radar data encoding apparatus 1000 includes units or modules configured to implement the steps in the radar data encoding methods shown in FIG. 3 to FIG. 7.

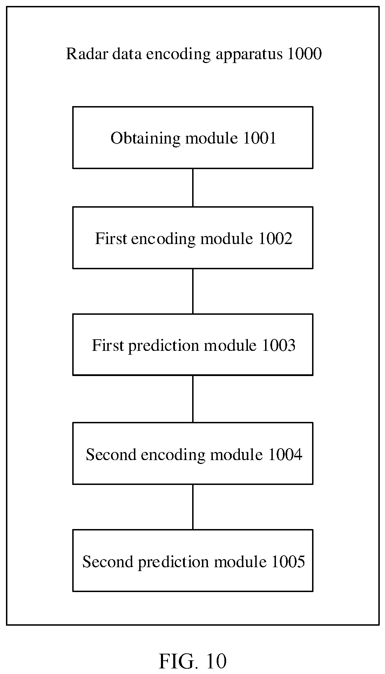

FIG. 10 is a diagram of a structure of a radar data encoding apparatus according to an embodiment of this application. The apparatus may be deployed in any apparatus, device, platform, or device cluster that has a computing capability, for example, may be a computer or a server. The apparatus may be deployed in the encoder shown in FIG. 3, to implement encoding and compression of radar data.

As shown in FIG. 10, the radar data encoding apparatus 1000 includes at least an obtaining module 1001, a first encoding module 1002, and a first prediction module 1003. The obtaining module 1001 is configured to obtain to-be-encoded data, where the to-be-encoded data is raw data or point cloud data of a radar, and when the to-be-encoded data is the raw data, the to-be-encoded data includes first attribute data, second attribute data, and third attribute data of different modals. The first encoding module 1002 is configured to encode the first attribute data, to obtain first encoded data. The first prediction module 1003 is configured to predict the second attribute data and the third attribute data based on the first attribute data, to obtain a predicted value of the second attribute data and a predicted value of the third attribute data. The first encoding module 1002 is further configured to encode the second attribute data based on the predicted value of the second attribute data, to obtain second encoded data; and encode the third attribute data based on the predicted value of the third attribute data, to obtain third encoded data.

In another possible implementation, the first prediction module 1003 is specifically configured to: an attribute value corresponding to a first moment in the first attribute data to be 0, both predicted values corresponding to the first moment in the second attribute data and the third attribute data to be 0, where attribute data with a predicted value 0 is configured to skip being encoded.

In another possible implementation, the first prediction module 1003 is specifically configured to: obtain a change characteristic of the first attribute data; determine a predicted value of the second attribute data at a current moment based on the change characteristic of the first attribute data and an attribute value of the second attribute data at a previous moment; and determine a predicted value of the third attribute data at the current moment based on the change characteristic of the first attribute and an attribute value of the third attribute data at the previous moment.

In another possible implementation, the obtaining a change characteristic of first attribute data includes: determining the change characteristic of the first attribute data based on an attribute value of the first attribute data at the current moment and an attribute value of the first attribute data at the previous moment.

In another possible implementation, the first attribute data, the second attribute data, and the third attribute data each are any one of distance information, signal intensity information, angle information, and reflectivity information.

In another possible implementation, when the to-be-encoded data is the point cloud data, the to-be-encoded data includes fourth attribute data, fifth attribute data, and sixth attribute data of different modals. The radar data encoding apparatus 1000 provided in this embodiment of this application further includes a second encoding module 1004 and a second prediction module 1005. The second encoding module 1004 is configured to separately encode the fourth attribute data and the fifth attribute data, to obtain fourth encoded data and fifth encoded data. The second prediction module 1005 is configured to predict the sixth attribute data based on the fourth attribute data and the fifth attribute data, to obtain a predicted value of the sixth attribute. The second encoding module is further configured to encode the sixth attribute based on the predicted value of the sixth attribute, to obtain sixth encoded data.

In another possible implementation, the second prediction module 1005 is specifically configured to: obtain change characteristics of the fourth attribute data and the fifth attribute data; and determine a predicted value of the sixth attribute data at a current moment based on the change characteristics of the fourth attribute data and the fifth attribute data and an attribute value of the sixth attribute data at a previous moment.

In another possible implementation, an implementation of obtaining the change characteristics of the fourth attribute data and the fifth attribute data is: determining an attribute value of the fourth attribute data and the change characteristic of the fifth attribute data based on an attribute value of the fourth attribute data and an attribute value of the fifth attribute data at the previous moment and an attribute value of the fourth attribute data and an attribute value of the fifth attribute data at the current moment.

The radar data encoding apparatus 1000 according to this embodiment of this application may correspondingly perform the method described in embodiments of this application, and the foregoing and other operations and/or functions of the modules in the radar data encoding apparatus 1000 are separately used to implement corresponding procedures of the methods in FIG. 3 to FIG. 7. For brevity, details are not described herein again.

Correspondingly, an embodiment of this application further provides a radar data decoding apparatus 1100. The radar data decoding apparatus 1100 includes units or modules configured to implement the steps in the radar data decoding methods shown in FIG. 8 and FIG. 9.

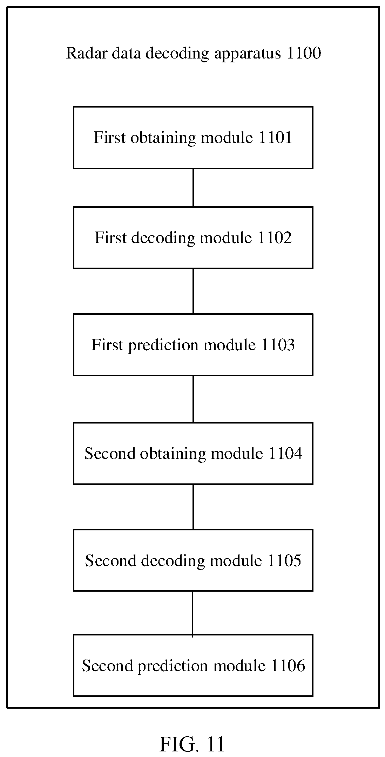

FIG. 11 is a diagram of a structure of a radar data decoding apparatus according to an embodiment of this application. The apparatus may be deployed in any apparatus, device, platform, or device cluster that has a computing capability, for example, may be a computer or a server. The apparatus may be deployed in the decoder shown in FIG. 3, to decode encoded data of a radar and reconstruct radar data.

As shown in FIG. 11, the radar data decoding apparatus 1100 includes at least a first obtaining module 1101, a first decoding module 1102, and a first prediction module 1103. The first obtaining module 1101 is configured to: when radar data is raw data, obtain first encoded data. The first decoding module 1102 is configured to decode the first encoded data, to obtain first attribute data. The first prediction module 1103 is configured to predict second attribute data and third attribute data based on the first attribute data, to obtain a predicted value of the second attribute data and a predicted value of the third attribute data. The first decoding module 1102 is further configured to: decode second encoded data and third encoded data, to obtain a residual value of the second attribute data and a residual value of the third attribute data; obtain the second attribute data based on the predicted value of the second attribute data and the residual value of the second attribute data; and obtain the third attribute data based on the predicted value of the third attribute data and the residual value of the third attribute data.

In another possible implementation, the radar data decoding apparatus 1100 provided in this embodiment of this application further includes a second obtaining module 1104, a second decoding module 1105, and a second prediction module 1106. The second obtaining module 1104 is configured to: when the radar data is point cloud data, obtain fourth encoded data and fifth encoded data. The second decoding module 1105 is configured to separately decode the fourth encoded data and the fifth encoded data, to obtain fourth attribute data and fifth attribute data. The second prediction module 1106 is configured to predict sixth attribute data based on the fourth attribute data and the fifth attribute data, to obtain a predicted value of the sixth attribute data. The second decoding module is further configured to: decode sixth encoded data, to obtain a residual value of the sixth attribute data, and obtain the sixth attribute data based on the predicted value of the sixth attribute data and the residual value of the sixth attribute data.

The radar data decoding apparatus 1100 according to this embodiment of this application may correspondingly perform the method described in embodiments of this application, and the foregoing and other operations and/or functions of the modules in the radar data decoding apparatus 1100 are separately used to implement corresponding procedures of the methods in FIG. 8 and FIG. 9. For brevity, details are not described herein again.

Based on a same concept as the foregoing method embodiments, an embodiment of this application further provides a computing device. The electronic device includes at least a processor and a memory. The memory stores a program. When the processor executes the program, units or modules in the steps in the methods shown in FIG. 3 to FIG. 9 may be implemented.

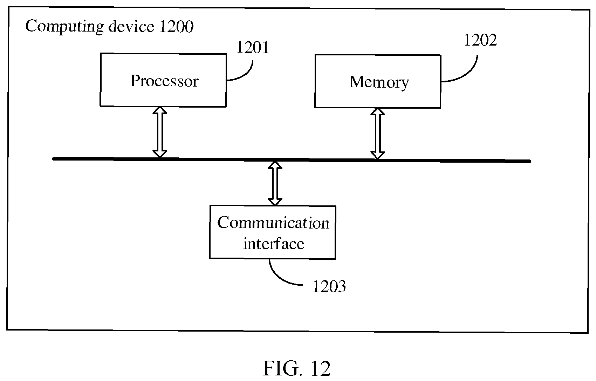

FIG. 12 is a diagram of a structure of a computing device according to an embodiment of this application.

As shown in FIG. 12, the computing device 1200 includes at least one processor 1201, a memory 1202, and a communication interface 1203. The processor 1201, the memory 1202, and the communication interface 1203 may be communicatively connected in a wired (for example, a bus) manner, or may be communicatively connected in a wireless manner. The communication interface 1203 is configured to receive data (for example, radar data) sent by another device. The memory 1202 stores computer instructions, and the processor 1201 executes the computer instructions to perform the method in the foregoing method embodiments.

It should be understood that, in this embodiment of this application, the processor 1201 may be a central processing unit CPU, or the processor 1201 may be another general purpose processor, a digital signal processor (digital signal processor, DSP), or an application-specific integrated circuit (application-specific integrated circuit, ASIC), a field programmable gate array (field programmable gate array, FPGA) or another programmable logic device, a discrete gate or transistor logic device, a discrete hardware component, or the like. The general-purpose processor may be a microprocessor, any conventional processor, or the like.

The memory 1202 may include a read-only memory and a random access memory, and provide instructions and data for the processor 1201. The memory 1202 may further include a nonvolatile random access memory.

The memory 1202 may be a volatile memory or a nonvolatile memory, or may include both a volatile memory and a nonvolatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), and serves as an external cache. Through example but not limitative description, many forms of RAMs may be used, for example, a static random access memory (static RAM, SRAM), a dynamic random access memory (DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

It should be understood that the computing device 1200 according to this embodiment of this application may perform and implement the methods shown in FIG. 3 to FIG. 9 in embodiments of this application. For detailed descriptions of implementations of the methods, refer to the foregoing descriptions. For brevity, details are not described herein again.

An embodiment of this application provides a computer-readable storage medium. The computer-readable storage medium stores a computer program. When the computer instructions are executed by a processor, the foregoing methods are implemented.

An embodiment of this application provides a chip. The chip includes at least one processor and an interface. The at least one processor determines program instructions or data by using the interface. The at least one processor is configured to execute the program instructions to implement the foregoing methods.

An embodiment of this application provides a computer program or a computer program product. The computer program or the computer program product includes instructions. When the instructions are executed, a computer is enabled to perform the foregoing methods.

A person of ordinary skill in the art may be further aware that, in combination with the examples described in embodiments disclosed in this specification, units and algorithm steps may be implemented by electronic hardware, computer software, or a combination of the two. To clearly describe interchangeability between the hardware and the software, compositions and steps of each example have generally been described in the foregoing specification based on functions. Whether the functions are performed by hardware or software depends on particular applications and design constraint conditions of the technical solutions. A person of ordinary skill in the art may use different methods to implement the described functions for each particular application, but it should not be considered that the implementation goes beyond the scope of this application.

The steps of the methods or algorithms described in the embodiments disclosed in this specification may be implemented by hardware and a software module executed by the processor or a combination of hardware and a software module executed by the processor. The software module may be configured in a random access memory (RAM), a memory, a read-only memory (ROM), an electrically programmable ROM, an electrically erasable programmable ROM, a register, a hard disk, a removable disk, a CD-ROM, or a storage medium in any other forms well-known in the art.

In the foregoing specific implementations, the objective, technical solutions, and beneficial effects of this application are further described in detail. It should be understood that the foregoing descriptions are merely specific implementations of this application, but are not intended to limit the protection scope of this application. Any modification, equivalent replacement, or improvement made without departing from the spirit and principle of this application should fall within the protection scope of this application.

## Claims

1. A radar data encoding method, comprising:
obtaining to-be-encoded data, wherein the to-be-encoded data is raw data or point cloud data of a radar, and when the to-be-encoded data is the raw data, the to-be-encoded data comprises first attribute data, second attribute data, and third attribute data of different modals;
encoding the first attribute data, to obtain first encoded data;
predicting the second attribute data and the third attribute data based on the first attribute data, to obtain a predicted value of the second attribute data and a predicted value of the third attribute data;
encoding the second attribute data based on the predicted value of the second attribute data, to obtain second encoded data; and
encoding the third attribute data based on the predicted value of the third attribute data, to obtain third encoded data.

2. The method according to claim 1, wherein the predicting the second attribute data and the third attribute data based on the first attribute data, to obtain a predicted value of the second attribute data and a predicted value of the third attribute data comprises:
an attribute value corresponding to a first moment in the first attribute data being 0, and both predicted values corresponding to the first moment in the second attribute data and the third attribute data being 0, wherein the attribute data with a predicted value 0 is configured to skip being encoded.

3. The method according to claim 1 or 2, wherein the predicting the second attribute data and the third attribute data based on the first attribute data, to obtain a predicted value of the second attribute data and a predicted value of the third attribute data comprises:
obtaining a change characteristic of the first attribute data;
determining a predicted value of the second attribute data in a current frame based on the change characteristic of the first attribute data and an attribute value of the second attribute data in an encoded frame; and
determining a predicted value of the third attribute data in the current frame based on the change characteristic of the first attribute and an attribute value of the third attribute data in the encoded frame, wherein
the change characteristic indicates a change characteristic of the first attribute data between a frame corresponding to the encoded frame and a frame corresponding to the current frame.

4. The method according to claim 3, wherein the obtaining a change characteristic of the first attribute data comprises:
determining the change characteristic of the first attribute data based on an attribute value of the first attribute data in the encoded frame and an attribute value of the first attribute data in the current frame.

5. The method according to any one of claims 1 to 4, wherein the first attribute data, the second attribute data, and the third attribute data each are any one of distance data, signal intensity data, angle data, and reflectivity data.

6. The method according to any one of claims 1 to 5, wherein when the to-be-encoded data is the point cloud data, the to-be-encoded data comprises fourth attribute data, fifth attribute data, and sixth attribute data of different modals; and
the method further comprises:
separately encoding the fourth attribute data and the fifth attribute data, to obtain fourth encoded data and fifth encoded data;
predicting the sixth attribute data based on the fourth attribute data and the fifth attribute data, to obtain a predicted value of the sixth attribute; and
encoding the sixth attribute based on the predicted value of the sixth attribute, to obtain the sixth encoded data.

7. The method according to claim 6, wherein the predicting the sixth attribute data based on the fourth attribute data and the fifth attribute data, to obtain a predicted value of the sixth attribute comprises:
obtaining change characteristics of the fourth attribute data and the fifth attribute data; and
determining a predicted value of the sixth attribute data in a current frame based on the change characteristics of the fourth attribute data and the fifth attribute data and an attribute value of the sixth attribute data in an encoded frame, wherein
the change characteristics indicate change characteristics of the fourth attribute data and the fifth attribute data between a frame corresponding to the encoded frame and a frame corresponding to the current frame.

8. The method according to claim 7, wherein the obtaining change characteristics of the fourth attribute data and the fifth attribute data comprises:
determining an attribute value of the fourth attribute data and the change characteristic of the fifth attribute data based on an attribute value of the fourth attribute data and an attribute value of the fifth attribute data in the encoded frame, and an attribute value of the fourth attribute data and an attribute value of the fifth attribute data in the current frame.

9. A radar data decoding method, comprising:
when the radar data is raw data, obtaining first encoded data;
decoding the first encoded data, to obtain first attribute data;
predicting second attribute data and third attribute data based on the first attribute data, to obtain a predicted value of the second attribute data and a predicted value of the third attribute data;
decoding second encoded data and third encoded data, to obtain a residual value of the second attribute data and a residual value of the third attribute data;
obtaining the second attribute data based on the predicted value of the second attribute data and the residual value of the second attribute data; and
obtaining the third attribute data based on the predicted value of the third attribute data and the residual value of the third attribute data.

10. The method according to claim 9, comprising:
when the radar data is point cloud data, obtaining fourth encoded data and fifth encoded data;
separately decoding the fourth encoded data and the fifth encoded data, to obtain fourth attribute data and fifth attribute data;
predicting sixth attribute data based on the fourth attribute data and the fifth attribute data, to obtain a predicted value of the sixth attribute data;
decoding sixth encoded data, to obtain a residual value of the sixth attribute data; and
obtaining the sixth attribute data based on the predicted value of the sixth attribute data and the residual value of the sixth attribute data.

11. A radar data encoding apparatus, comprising:
an obtaining module, configured to obtain to-be-encoded data, wherein the to-be-encoded data is raw data or point cloud data of a radar, and when the to-be-encoded data is the raw data, the to-be-encoded data comprises first attribute data, second attribute data, and third attribute data of different modals;
a first encoding module, configured to encode the first attribute data, to obtain first encoded data; and
a first prediction module, configured to predict the second attribute data and the third attribute data based on the first attribute data, to obtain a predicted value of the second attribute data and a predicted value of the third attribute data, wherein
the first encoding module is further configured to encode the second attribute data based on the predicted value of the second attribute data, to obtain second encoded data; and
encode the third attribute data based on the predicted value of the third attribute data, to obtain third encoded data.

12. The apparatus according to claim 11, wherein the first prediction module is specifically configured to: an attribute value corresponding to a first moment in the first attribute data to be 0, and both predicted values corresponding to the first moment in the second attribute data and the third attribute data to be 0, wherein the attribute data with a predicted value 0 is configured to skip being encoded.

13. The apparatus according to claim 11 or 12, wherein the first prediction module is specifically configured to:
obtain a change characteristic of the first attribute data;
determine a predicted value of the second attribute data in a current frame based on the change characteristic of the first attribute data and an attribute value of the second attribute data in an encoded frame, wherein N is a positive integer; and
determine a predicted value of the third attribute data in the current frame based on the change characteristic of the first attribute and an attribute value of the third attribute data in the encoded frame, wherein
the change characteristic indicates a change characteristic of the first attribute data between a frame corresponding to the encoded frame and a frame corresponding to the current frame.

14. The apparatus according to claim 13, wherein the obtaining a change characteristic of the first attribute data comprises:
determining the change characteristic of the first attribute data based on an attribute value of the first attribute data in the encoded frame and an attribute value of the first attribute data in the current frame.

15. The apparatus according to claim 11, wherein the first attribute data, the second attribute data, and the third attribute data each are any one of distance data, signal intensity data, angle data, and reflectivity data.

16. The apparatus according to any one of claims 11 to 15, wherein when the to-be-encoded data is the point cloud data, the to-be-encoded data comprises fourth attribute data, fifth attribute data, and sixth attribute data of different modals; and
the apparatus further comprises:
a second encoding module, configured to separately encode the fourth attribute data and the fifth attribute data, to obtain fourth encoded data and fifth encoded data; and
a second prediction module, configured to predict the sixth attribute data based on the fourth attribute data and the fifth attribute data, to obtain a predicted value of the sixth attribute, wherein
the second encoding module is further configured to encode the sixth attribute based on the predicted value of the sixth attribute, to obtain the sixth encoded data.

17. The apparatus according to claim 16, wherein the second prediction module is specifically configured to:
obtain change characteristics of the fourth attribute data and the fifth attribute data; and
determine a predicted value of the sixth attribute data in a current frame based on the change characteristics of the fourth attribute data and the fifth attribute data and an attribute value of the sixth attribute data in an encoded frame, wherein
the change characteristics indicate change characteristics of the fourth attribute data and the fifth attribute data between a frame corresponding to the encoded frame and a frame corresponding to the current frame.

18. The apparatus according to claim 17, wherein the obtaining change characteristics of the fourth attribute data and the fifth attribute data comprises:
determining an attribute value of the fourth attribute data and the change characteristic of the fifth attribute data based on an attribute value of the fourth attribute data and an attribute value of the fifth attribute data in the encoded frame, and an attribute value of the fourth attribute data and an attribute value of the fifth attribute data in the current frame.

19. A radar data decoding apparatus, comprising:
a first obtaining module, configured to: when the radar data is raw data, obtain first encoded data;
a first decoding module, configured to decode the first encoded data, to obtain first attribute data;
a first prediction module, configured to predict second attribute data and third attribute data based on the first attribute data, to obtain a predicted value of the second attribute data and a predicted value of the third attribute data, wherein
the first decoding module is further configured to: decode the second encoded data and the third encoded data, to obtain a residual value of the second attribute data and a residual value of the third attribute data;
obtain the second attribute data based on the predicted value of the second attribute data and the residual value of the second attribute data; and
obtain the third attribute data based on the predicted value of the third attribute data and the residual value of the third attribute data.

20. The apparatus according to claim 19, further comprising
a second obtaining module, configured to: when the radar data is point cloud data, obtain fourth encoded data and fifth encoded data;
a second decoding module, configured to separately decode the fourth encoded data and the fifth encoded data, to obtain fourth attribute data and fifth attribute data; and
a second prediction module, configured to predict sixth attribute data based on the fourth attribute data and the fifth attribute data, to obtain a predicted value of the sixth attribute data, wherein
the second decoding module is further configured to decode sixth encoded data, to obtain a residual value of the sixth attribute data; and
obtain the sixth attribute data based on the predicted value of the sixth attribute data and the residual value of the sixth attribute data.

21. A computing device, comprising a memory and a processor, wherein the memory stores executable code, and the processor executes the executable code to implement the method according to any one of claims 1 to 10.

22. A computer-readable storage medium, wherein the computer-readable storage medium stores a computer program, and when the computer program is executed on a computer, the computer is enabled to perform the method according to any one of claims 1 to 10.
